# EUROPEAN PATENT APPLICATION

(11) **EP 4 642 171 A1**
(43) Date of publication of application: **29.10.2025**
(21) Application number: 23914532.9
(22) Date of filing: 25.12.2023
(51) Int. Cl.: H05K 1/02, H05K 1/16, H05K 1/11, H05K 3/00, H01L 23/538

(54) **CIRCUIT STRUCTURE, ELECTRONIC DEVICE, AND MUTUAL-CAPACITANCE STRUCTURE DESIGN METHOD**

(30) Priority: 07.01.2023 CN 202310022403
(71) Applicant: Sanechips Technology Co., Ltd., Shenzhen, Guangdong 518055 (CN)
(72) Inventor: OUYANG, Keqing, Shenzhen, Guangdong 518055 (CN); WU, Feng, Shenzhen, Guangdong 518055 (CN); MA, Shineng, Shenzhen, Guangdong 518055 (CN); ZHANG, Jiangtao, Shenzhen, Guangdong 518055 (CN)
(74) Representative: Canzler & Bergmeier Patentanwälte Partnerschaft mbB
(86) International application number: PCT/CN2023/141371
(87) International publication number: WO 2024/146399

(57) **Abstract**

The present disclosure provides a circuit structure (100), an electronic device, and a mutual-capacitance structure design method. The circuit structure (100) comprises a carrier plate (1) and a plurality of signal pads (2) arranged on the carrier plate (1), and the circuit structure (100) further comprises mutual-capacitance structures (3) arranged on the carrier plate (1), wherein each mutual-capacitance structure (3) has a first end (31), a second end (32), and a mutual-capacitance coupling portion (33) located between the first end (31) and the second end (32), and the first end (31) and the second end (32) of each mutual-capacitance structure (3) are respectively connected to two of the plurality of signal pads (2).

## Description

### CROSS REFERENCE TO RELATED APPLICATIONS

The present disclosure claims the priority to Chinese Patent Application No. 202310022403.5 filed on January 7, 2023 and Chinese Patent Application No. 202310804534.9 filed on June 30, 2023, and the contents of the two Chinese patent applications are incorporated herein by reference in their entirety.

### TECHNICAL FIELD

The present disclosure relates to the technical field of electronic devices, and in particular, to a circuit structure, an electronic device, and a mutual-capacitance structure design method.

### BACKGROUND

With the development of Artificial Intelligence (AI) and big data, the requirements on signal transmission rate and bandwidth for high-speed Double Data Rate (DDR) become higher and higher. Meanwhile, due to the increasing functionality of chips, their size is getting larger and larger. Especially, for a chip with a large package size such as Central Processing Unit (CPU), an interconnect structure is required for mounting the chip to the system board. For products with DDR interface packaged with the interconnect structure, since the parallel interface rate becomes higher and higher, the chip package size becomes larger and larger, pins become denser and denser, and introduced crosstalk becomes a bottleneck restricting DDR performance.

Therefore, it is necessary to provide a new circuit structure, electronic device, and design method for a mutual-capacitance structure to solve the above problems.

### SUMMARY

The present disclosure provides a circuit structure, including a carrier board and a plurality of signal pads disposed on the carrier board, and the circuit structure further includes a mutual-capacitance structure, which may be disposed on the carrier board, the mutual-capacitance structure has a first end, a second end, and a mutual-capacitance coupling portion located between the first end and the second end, and the first end and the second end of the mutual-capacitance structure are connected to two of the plurality of signal pads, respectively

In addition, the present disclosure further provides an electronic device, including a chip device, an interconnect structure, and the above circuit structure. The chip device is electrically connected to the interconnect structure, the interconnect structure is provided with a plurality of pins, and the plurality of pins are electrically connected to the plurality of signal pads, respectively.

In addition, the present disclosure further provides a design method for a mutual-capacitance structure, the mutual-capacitance structure is used in the above circuit structure, and the design method includes: acquiring an original crosstalk value of an interconnect structure; setting a target mutual-capacitance value of the mutual-capacitance structure according to the original crosstalk value; building a model of the mutual-capacitance structure; setting dimensional parameters of the mutual-capacitance structure as variable values in the model of the mutual-capacitance structure; adjusting the dimensional parameters of the mutual-capacitance structure according to a preset rule, and acquiring a mutual-capacitance value of the mutual-capacitance structure in real time; and outputting the dimensional parameters of the mutual-capacitance structure when the mutual-capacitance value of the mutual-capacitance structure is the same as the target mutual-capacitance value.

### BRIEF DESCRIPTION OF DRAWINGS

In order to illustrate the technical solutions in embodiments of the present disclosure or in the existing technology more clearly, drawings for the illustration of the embodiments or the existing technology will be briefly described below. Apparently, the drawings described below are merely for some embodiments of the present disclosure, and other drawings can be derived by those of ordinary skill in the art from the drawings described below without any inventive work.
FIG. 1 is a sectional view of a circuit structure according to an embodiment of the present disclosure;
FIG. 2 is a schematic diagram illustrating connection of a mutual-capacitance structure according to an embodiment of the present disclosure;
FIG. 3a and FIG. 3b are schematic structural diagrams of circuit structures according to the embodiments of the present disclosure;
FIG. 4a and FIG. 4b are schematic structural diagrams of circuit structures according to the embodiments of the present disclosure;
FIG. 5a, FIG. 5b, FIG. 5c, FIG. 5d, FIG. 5e, and FIG. 5f are schematic diagrams of different mutual-capacitance structures according to the embodiments of the present disclosure;
FIG. 6 is a schematic diagram of an application scenario of a circuit structure according to an embodiment of the present disclosure;
FIG. 7 is a schematic diagram illustrating the formation principle of crosstalk according to an embodiment of the present disclosure;
FIG. 8 shows a Far End Crosstalk (FEXT) simulation result according to a related design;
FIG. 9 shows a FEXT simulation result according to the embodiments of the present disclosure; and
FIG. 10 is a flowchart illustrating a design method for mutual-capacitance structure according to an embodiment of the present disclosure.

### Description of reference numerals:

| reference numeral | name | reference numeral | name |
|---|---|---|---|
| 100 | circuit structure | 332 | second coupling portion |
| 1 | substrate (carrier board) | 332a | second comb tooth |
| 2 | signal pad | 34 | connection post |
| 21 | first pad | 4 | interconnect structure |
| 22 | second pad | 41 | pin |
| 3 | mutual-capacitance structure | 5 | chip packaging structure |
| 31 | first end | 51 | chip device |
| 32 | second end | 52 | Dual-Inline-Memory-Module (DIMM) |
| 33 | mutual-capacitance coupling portion | 53 | **DDR** memory |
| 331 | first coupling portion | 6 | circuit motherboard |
| 331a | first comb tooth | L1, L2 | conductive layer |
| 3-1 | first mutual-capacitance coupling portion | 3-2 | second mutual-capacitance coupling portion |

The implementation of the objectives of the present disclosure and the functional features and advantages of the present disclosure will be further described in conjunction with the embodiments and with reference to the drawings.

### DETAIL DESCRIPTION OF EMBODIMENTS

The technical solutions of the embodiments of the present disclosure will be clearly and completely described below in conjunction with the accompanying drawings for the embodiments of the present disclosure. Apparently, the embodiments to be described are only some rather than all of the embodiments of the present disclosure. Based on the embodiments of the present disclosure, all other embodiments obtained by those of ordinary skill in the art without creative efforts shall fall within the scope of the present disclosure.

It should be noted that the directional indications (such as "above", "under", "left", "right", "front", "back" ......) in the embodiments of the present disclosure are merely used for explaining a relative positional relationship between components and motions of the components in a specific posture (as shown in the drawings). If the specific posture changes, the directional indication will change accordingly.

In addition, the description involving the terms "first", "second" and the like in the present disclosure is merely for descriptive purposes, and should not be interpreted as indicating or implying relative importance or implicitly indicating the number of the technical features referred to. Thus, a feature defined by "first" or "second" may explicitly or implicitly include at least one such feature. **In** the description of the present disclosure, unless specifically limited otherwise, "a plurality" means at least two, such as two or three.

**In** the present disclosure, unless expressly defined or limited otherwise, the terms "connect", "fix" and the like should be interpreted broadly. For example, "fix" may refer to a fixed connection, a detachable connection, or being integrated to be one; it can be a mechanical connection or an electrical connection, it can be a direct connection or an indirect connection through an intermediate medium, it can be the communication of insides of two elements or the interaction relationship between the two elements. For those of ordinary skill in the art, the specific meaning of the above-mentioned terms in the present disclosure can be understood according to specific circumstances.

In addition, the technical solutions in different embodiments of the present disclosure may be combined with each other. However, such combination should be based on the premise that it can be implemented by those of ordinary skill in the art. When a combination of the technical solutions causes contradiction or cannot be implemented, such combination should not be considered to exist, and is not within the scope of the present disclosure.

In the related technology, improvements are generally made to the interconnect structure itself, for example, the interconnect structure with a shorter spring piece is adopted. However, in order to ensure good mechanical connectivity, the spring piece cannot be further shortened due to the limitations of mechanical stress and reliability, that is, the crosstalk introduced by the interconnect structure cannot be completely eliminated or reduced to an acceptable level.

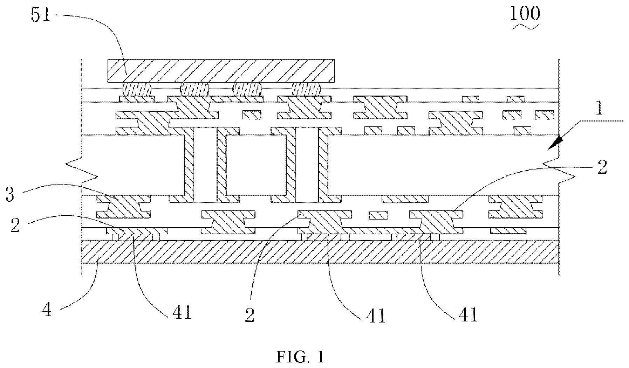

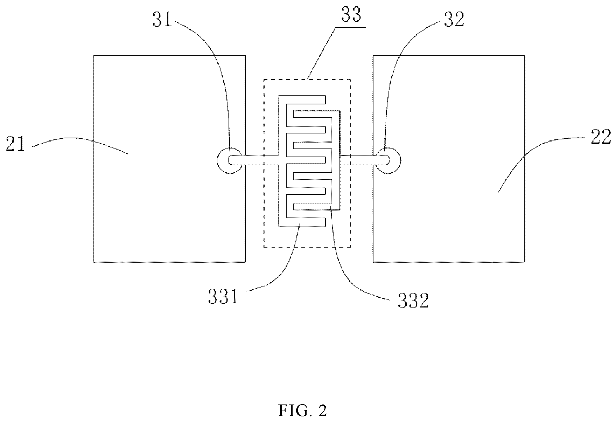

As shown in FIG. 1 and FIG. 2, in an embodiment of the present disclosure, a circuit structure 100 includes a substrate 1 (which may also be referred to as a carrier board) and a plurality of signal pads 2 (21, 22) disposed on the substrate 1. The circuit structure 100 further includes a mutual-capacitance structure 3 disposed on the substrate 1. The mutual-capacitance structure 3 has a first end 31, a second end 32, and a mutual-capacitance coupling portion 33 located between the first end 31 and the second end 32, and the first end 31 and the second end 32 of the mutual-capacitance structure 3 are connected to two signal pads 2, respectively.

The term "circuit structure" in the present disclosure refers to any suitable circuit structure including a plurality of pads. These pads are electrically connected to other electrical components included in the circuit structure for electrical communication, and there may be crosstalk between electrical signals transmitted through the pads. In the present disclosure, by disposing the mutual-capacitance structure between the two signal pads 2, capacitive coupling effect is introduced between the two signal pads, so that inherent large mutual inductive coupling between the two signal pads can be cancelled out, which achieves a technical effect of reducing FEXT (Far End Crosstalk) between two electrical signals transmitted through the two signal pads.

In the present disclosure, the position relationship definition "the mutual-capacitance structure 3 is disposed on the substrate 1" may be understood as that the mutual-capacitance structure 3 is disposed on the substrate 1, or the mutual-capacitance structure 3 is disposed in the substrate 1, and the specific position of the mutual-capacitance structure 3 relative to the substrate 1 is not limited in the present disclosure.

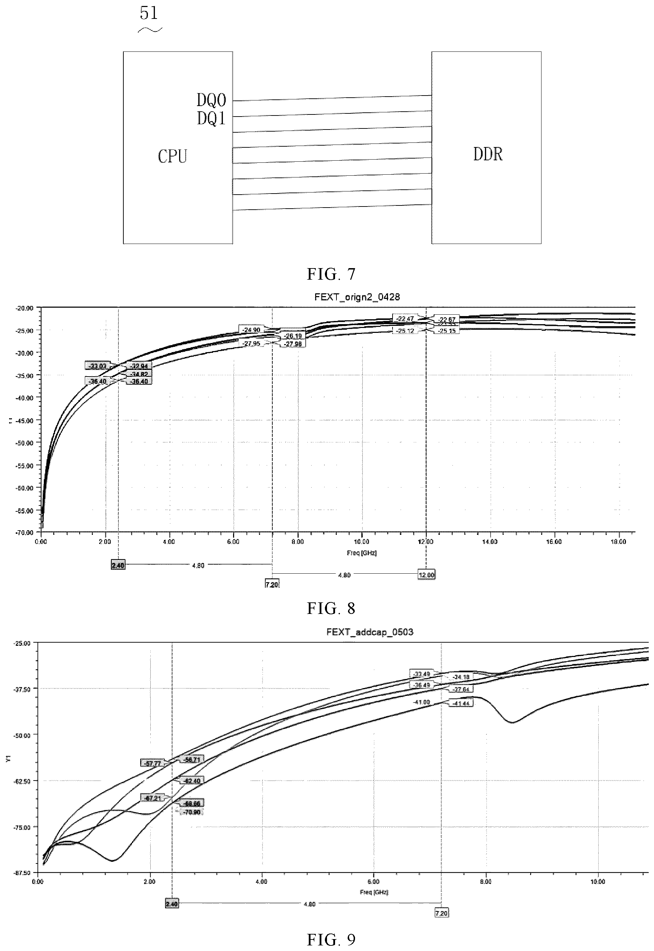

Additionally referring to FIG. 7, the circuit structure 100 proposed in the present disclosure can be applied to a main control chip product provided with a DDR interface, such as a CPU chip or a Field Programmable Gate Array (FPGA) chip, so as to realize high-rate parallel interface transmission of DDR4 and DDR5, and provide a basis for realizing DDR6 and subsequent standards with higher rate in the future. It should be understood that the circuit structure 100 may also be applied to a chip product/board product provided with any type of transmission/communication interface, which is not limited in the present disclosure.

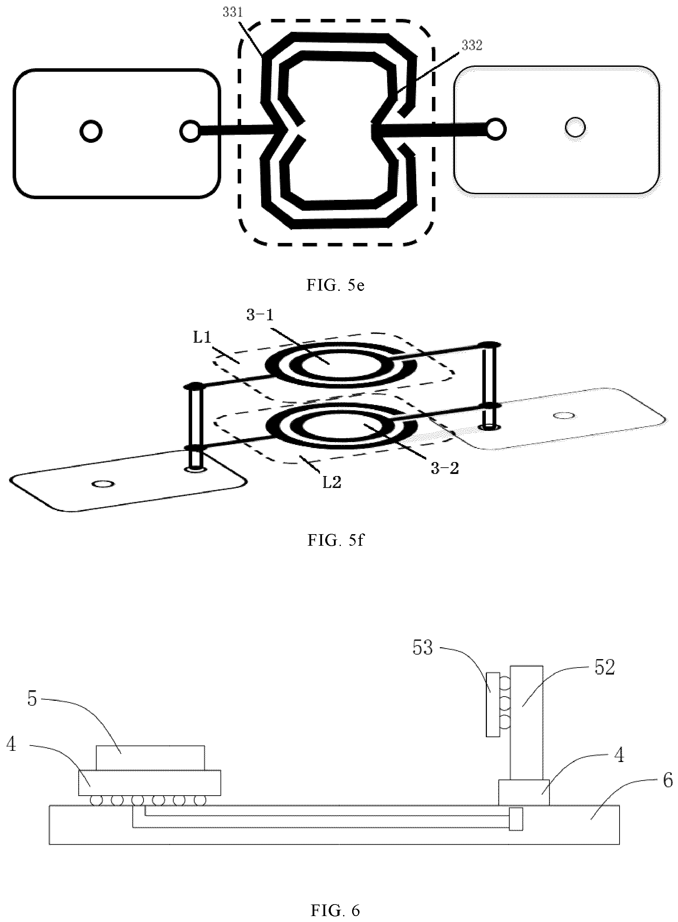

In FIG. 6 and FIG. 7, a CPU chip is used as an example for explanation. When there are multiple-channel dense parallel signal transmission between a CPU and a DDR interface, crosstalk occurs between adjacent signals. The DDR interface is characterized in that DQ signals (bidirectional data signals) are read and written simultaneously within 1 byte, near end crosstalk has little effect, and far-end crosstalk (FEXT) is dominant. For example, when the CPU transmits signals, a signal DQ0 crosses to a DDR memory side of a receiving end of a signal DQ1. As shown in FIG. 6, a chip packaging structure of the CPU is connected to a circuit motherboard 6 (e.g., a Printed Circuit Board (PCB)) through an interconnect structure 4, and pins 41 of the interconnect structure 4 are electrically connected to the signal pads 2 (see FIG. 1) to enable signal transmission; and accordingly, the interconnect structure 4 may introduce the FEXT. The FEXT is related to a crosstalk coefficient (Kf) and a coupling length, and the coupling length is related to lengths of the pins 41. The FEXT coefficient of unit length is proportional to a difference between mutual capacitance and mutual inductance, and if the mutual capacitance and the mutual inductance are equal to each other (for example, in a case of a strip line), the FEXT coefficient is 0, so that an effect of cancelling the crosstalk can be achieved. The mutual inductance between adjacent pins 41 of a conventional interconnect structure 4 is relatively large while the mutual capacitance of the interconnect structure 4 itself is relatively small, resulting in the FEXT being predominantly inductive. In the present disclosure, by providing the mutual-capacitance structure 3 and the signal pads 2 electrically connected to the pins 41, which is equivalent to introducing the mutual-capacitance structure 3 between two pins 41, the inherent large mutual inductive coupling between the densely arranged pins 41 of the interconnect structure 4 can be cancelled out, the FEXT between the two electric signals can be reduced or even cancelled out, ultimately achieving a high-speed, large-bandwidth parallel signal transmission.

Although the above and following descriptions of the present disclosure are given by taking the signal crosstalk caused by the interconnect structure as an example, the application of the present disclosure is not limited to circuits having interconnect structures, and the present disclosure is applicable to any circuit structure in which signal crosstalk is caused due to mutual inductive coupling.

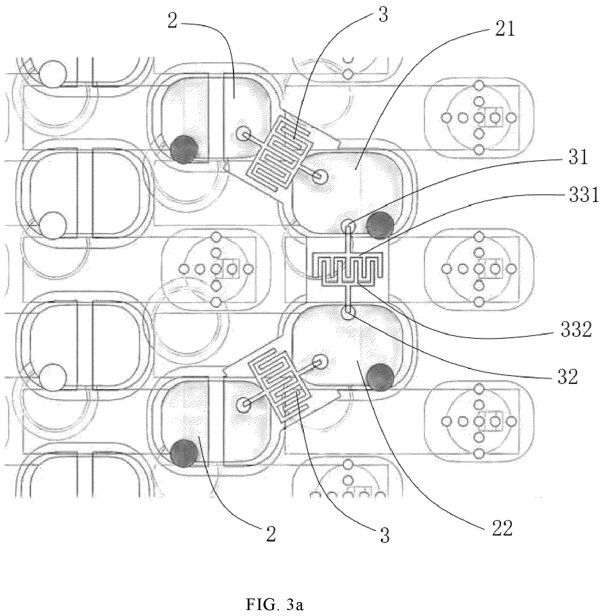

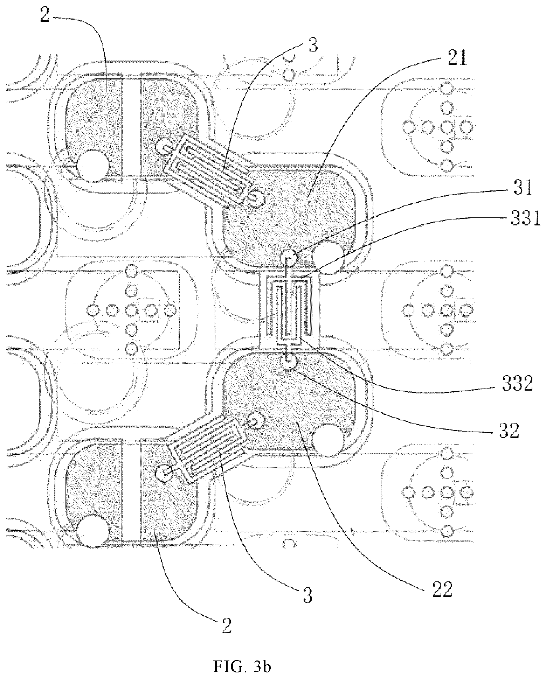

In an example, referring to FIG. 3a and FIG. 3b, the two signal pads 2 respectively connected to the first end 31 and the second end 32 of the mutual-capacitance structure 3 are disposed adjacent to each other. The two adjacent signal pads 2 are a first pad 21 and a second pad 22 respectively. The first end 31 of the mutual-capacitance structure 3 is connected to the first pad 21, and the second end 32 of the mutual-capacitance structure 3 is connected to the second pad 22. In general, a distance between two adjacent pins 41 of the interconnect structure 4 is relatively small, which may introduce significant crosstalk. The mutual-capacitance structure 3 may be introduced between any two adjacent pins 41 through the signal pads 2, that is, the mutual-capacitance structure 3 may be connected between any two adjacent signal pads 2, so as to reduce FEXT between adjacent signals. Certainly, in practical applications, the mutual-capacitance structure 3 may also be introduced between any two relevant signal pads 2 according to actual needs, such as according to an actual crosstalk conditions and pin 41 usage, not limited to between adjacent signal pads. The present disclosure imposes no restrictions on the specific positions of the two signal pads where the mutual capacitance structure is arranged.

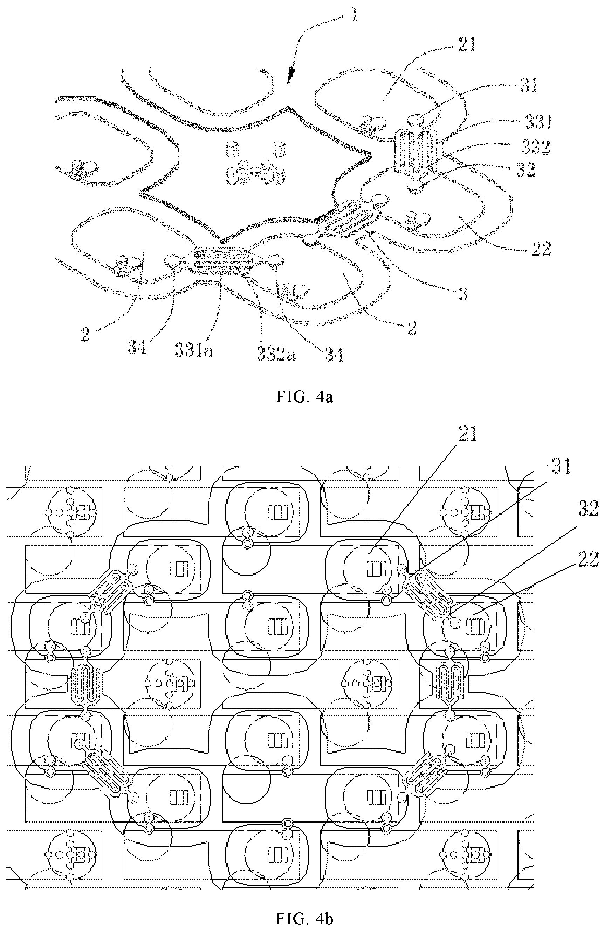

FIG. 2 illustrates a schematic diagram of an exemplary structure of the mutual-capacitance coupling portion 33 according to an embodiment of the present disclosure. FIG. 4a and FIG. 4b are schematic structural diagrams of a circuit structure according to an embodiment of the present disclosure. Referring to FIG. 2, FIG. 4a, and FIG. 4b, in this embodiment, the mutual-capacitance coupling portion 33 includes a first coupling portion 331 and a second coupling portion 332; one end of the first coupling portion 331 is connected to the first end 31 of the mutual-capacitance structure 3, and the other end of the first coupling portion 331 has one or more first comb teeth 331a; and one end of the second coupling portion 332 is connected to the second end 32 of the mutual-capacitance structure 3, and the other end of the second coupling portion 332 has one or more second comb teeth 332a. The shape of the first comb teeth and that of the second comb teeth are not limited in the present disclosure, the first comb teeth may be referred to as a first mutual-capacitance component, and the second comb teeth may be referred to as a second mutual-capacitance component.

**In** some possible implementations, in a case where there are a plurality of first comb teeth 331a and a plurality of second comb teeth 332a, the plurality of first comb teeth 331a and the plurality of second comb teeth 332a are staggered. As shown in FIG. 2, FIG. 4a, and FIG. 4b, each of the first coupling portion 331 and the second coupling portion 332 may have a multi-toothed rake-type structure or a comb-type structure, and the comb teeth of the first coupling portion 331 and the comb teeth of the second coupling portion 332 are arranged to be staggered with each other, thereby improving the mutual-capacitance effect. That is, in terms of spatial position, the comb teeth of the first and second coupling portions 331, 332 are arranged in the order of: the first comb tooth 331a, the second comb tooth 332a, the first comb tooth 331a, the second comb tooth 332a ..., so as to improve the mutual-capacitance effect, cancel the mutual inductance, and improve the FEXT suppression effect.

In an example, the first end 31 of the mutual-capacitance structure 3 is an end of the first coupling portion 331, that is, the end of the first coupling portion 331 which is not provided with the first comb tooth 331a; and the second end 32 of the mutual-capacitance structure 3 is an end of the second coupling portion 332, that is, the end of the second coupling portion 332 which is not provided with the second comb tooth 332a.

An implementation of the present disclosure is proposed based on the above examples: in a case where there are a plurality of first comb teeth 331a and a plurality of second comb teeth 332a, the number of the first comb teeth 331a is N, the number of the second comb teeth 332a is M, and one second comb tooth 332a is disposed between any two adjacent first comb teeth 331a; |N-M|≤1, where N is a positive integer greater than or equal to 2, and M is a positive integer. That is, the number of the first comb teeth 331a is a positive integer not less than 2, and a difference between the number of the first comb teeth 331a and the number of the second comb teeth 332a may be 1 or 0, for example, when the number of the first comb teeth 331a is 3, the number of the second comb teeth 332a may be 2, 3, or 4. Such multi-toothed coupling improves the coupling capacitance effect between the first coupling portion 331 and the second coupling portion 332, so that the mutual-capacitance effect can be improved within the same layer to cancel out the mutual inductance and thereby suppress the FEXT. Moreover, it is ensured that mutual capacitance can be generated between any adjacent comb teeth, so that the space occupied by the mutual-capacitance structure 3 can be effectively controlled.

**In** an example, the number of the first comb teeth 331a is an odd number not less than 3, and the number of the second comb teeth 332a is an even number not less than 2 and is less than the number of the first comb teeth 331a by 1. Thus, it is ensured that the second comb teeth 332a can be entirely encompassed by the first comb teeth 331a when the first coupling portion 331 and the second coupling portion 332 are fit, thereby improving the mutual capacitance effect.

Specific implementation shapes of the first coupling portion 331 and the second coupling portion 332 are not limited in the embodiments of the present disclosure. For example, the first comb tooth 331a and the second comb tooth 332a may have straight structures or arc-shaped structures.

**In** each of the above embodiments, although the structures of the first coupling portion 331 and the second coupling portion 332 are described using the term "comb tooth", "multi-toothed rake-type structure", or "comb-type structure", shapes, sizes, or numbers of the comb teeth are not limited in each embodiment of the present disclosure, and the comb teeth may have any shape and size and may be in any number as long as the mutual capacitance effect can be generated between the first coupling portion and the second coupling portion. For example, the comb teeth may be straight or curved, and the number of the comb teeth of the first or second coupling portion may be more than one or only one; the comb teeth may be strip-shaped or may be planes or curved surfaces with a certain area. **In** an example, each first comb tooth or each second comb tooth may has a shape of any one of: a shape of a straight strip, a shape of a curved strip, a shape of a plane (flat plate), or a shape of a curved surface (curved plate). The shape and size of the first comb tooth may be the same as or different from the shape and size of the second comb tooth.

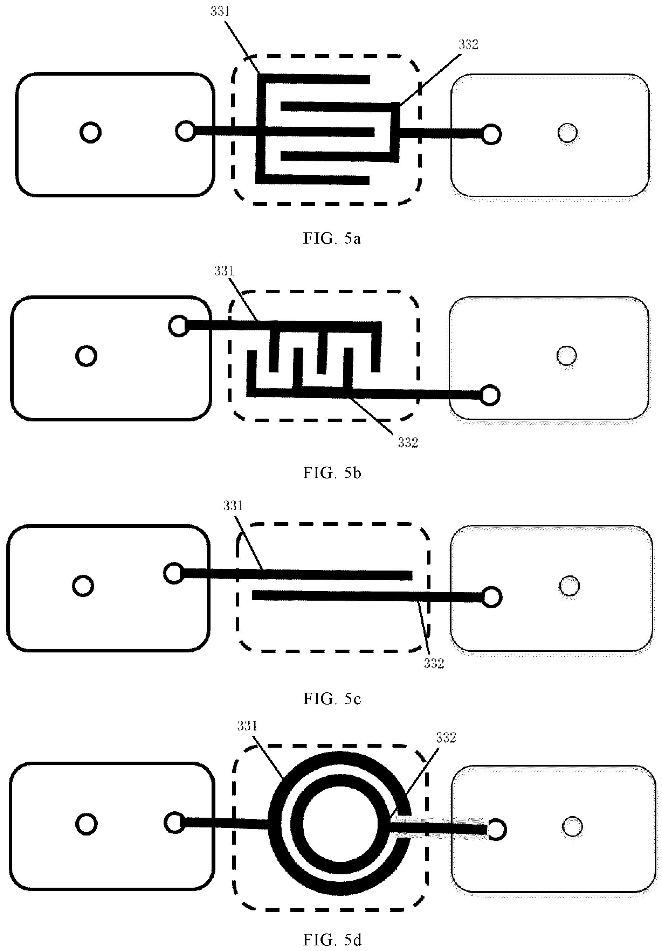

FIG. 5a, FIG. 5b, FIG. 5c, FIG. 5d, and FIG. 5e are schematic diagrams illustrating several examples of the mutual-capacitance structure according to the embodiments of the present disclosure.

**In** some possible implementations, the first coupling portion and the second coupling portion may each have a shape of at least one of: a shape of longitudinal comb teeth, a shape of transverse comb teeth, a shape of a long strip, and a shape of a ring.

For example, the mutual-capacitance coupling portion of the mutual-capacitance structure may be configured in different shapes. **In** some examples, the direction of a connection line between the first end and the second end of the mutual-capacitance structure may be referred to as a longitudinal direction, and the direction perpendicular to the connection line between the first end and the second end may be referred to as a transverse direction.

As shown in FIG. 5a, the first coupling portion 331 and the second coupling portion 332 of the mutual-capacitance coupling portion of the mutual-capacitance structure may each have the shape of longitudinal comb teeth, that is, the first coupling portion 331 includes a plurality of longitudinal first comb teeth, and the second coupling portion 332 includes a plurality of longitudinal second comb teeth.

As shown in FIG. 5b, the first coupling portion 331 and the second coupling portion 332 of the mutual-capacitance coupling portion of the mutual-capacitance structure may each have the shape of transverse comb teeth, that is, the first coupling portion 331 includes a plurality of transverse first comb teeth, and the second coupling portion 332 includes a plurality of transverse second comb teeth.

As shown in FIG. 5c, the first coupling portion 331 and the second coupling portion 332 of the mutual-capacitance coupling portion of the mutual-capacitance structure may each have the shape of a long strip.

As shown in FIG. 5d and FIG. 5e, the first coupling portion 331 and the second coupling portion 332 of the mutual-capacitance coupling portion of the mutual-capacitance structure may each have the shape of a ring. The ring may be a circular ring shown in FIG. 5d or another type of ring shown in FIG. 5e, and may also be an elliptical ring or a rectangular ring, and the specific shape of the ring is not limited in the present disclosure. In addition, it may be the case that one of the first coupling portion 331 and the second coupling portion 332 is an open ring and the other is a complete ring which is disposed within the open ring and has a smaller size (FIG. 5d), or it may be the case that one of the first coupling portion 331 and the second coupling portion 332 is one open ring and the other is the another smaller open ring disposed inside the first open ring (FIG. 5e).

It should be understood that the shapes of the first coupling portion and the second coupling portion may be set by those of ordinary skill in the art according to actual situations, and the specific shape of the mutual-capacitance coupling portion is not limited in the present disclosure. Moreover, in a case where one mutual-capacitance structure includes a plurality of mutual-capacitance coupling portions, the shapes of different mutual-capacitance coupling portions of the same mutual-capacitance structure may be different, which is not limited in the present disclosure.

As shown in FIG. 3a, FIG. 3b, and FIG. 4a, a length, width and number of the first comb teeth/tooth 331a, a distance between two adjacent first comb teeth 331a, a length, width and number of the second comb teeth/tooth 332a, and a distance between two adjacent second comb teeth 332a, are determined according to an original crosstalk value of the interconnect structure 4. Thus, the first coupling portion 331 and the second coupling portion 332 between every two signal pads 2 may have inconsistent specifications, as long as it is ensured that the mutual capacitance generated by the first comb teeth 331a extending from the first coupling portion 331 and the second comb teeth 332a extending from the second coupling portion 332 which are staggered with each other can cancel out the mutual inductance.

In practical applications, considering reliability of the manufacturing technology of the carrier board 1, the mutual-capacitance structure 3 may be adjusted, for example, as shown in FIG. 4a, a part at which one or more first comb teeth 331a converge may be subjected to a thickening and strengthening process, and a part from which a first comb tooth 331a is extended may be subjected to a chamfering process or a fillet process; similarly, the structure of the second coupling portion 332 may also be optimized accordingly.

In some examples, as shown in FIG. 1 to FIG. 4b and FIG. 5a to FIG. 5f, the first and second coupling portions of the mutual-capacitance coupling portion are disposed in the same conductive layer (also referred to as a "wiring layer") (referred to as "coplanar coupling"). In this way, the area of the capacitance can be increased.

In some possible implementations, the number of the mutual-capacitance coupling portion of the mutual-capacitance structure may be one or more. In a case where there are a plurality of mutual-capacitance coupling portions (the number of the mutual-capacitance coupling portions is plural), the plurality of mutual-capacitance coupling portions may be disposed in different conductive layers (referred to as "multi-layer coplanar coupling"), so as to reduce situations of poor crosstalk cancellation effect caused by size limitation. The plurality of mutual-capacitance coupling portions may also be disposed in the same conductive layer (referred to as "single-layer coplanar coupling"), so as to obtain better mutual capacitance performance and reduce processing cost. That is, the mutual-capacitance structure may be configured as a single-layer coplanar coupling structure or a multi-layer coplanar coupling structure.

FIG. 5f is a schematic diagram of a mutual-capacitance structure including two mutual-capacitance coupling portions according to an embodiment of the present disclosure. As shown in FIG. 5f, the mutual-capacitance structure includes a first mutual-capacitance coupling portion 3-1 and a second mutual-capacitance coupling portion 3-2, a first coupling portion and a second coupling portion of the first mutual-capacitance coupling portion 3-1 are disposed in the same conductive layer L1, a first coupling portion and a second coupling portion of the second mutual-capacitance coupling portion 3-2 are disposed in the same conductive layer L2, and L1 and L2 are different conductive layers. In other examples, L1 and L2 may be the same conductive layer.

In some possible implementations, the signal pads 2 and the mutual-capacitance coupling portion 33 may be disposed in the same conductive layer of the carrier board 1 or in different conductive layers. Referring to FIG. 1 and FIG. 4a, in this embodiment, the signal pads 2 and the mutual-capacitance coupling portion 33 are disposed in different conductive layers of the carrier board 1. The carrier board 1 further includes a plurality of connection posts 34 disposed between different conductive layers, and the first coupling portion 331 and the second coupling portion 332 are respectively connected to the first pad 21 and the second pad 22 through the connection posts 34.

In the circuit structure 100, the carrier board 1 may be formed by packaging an insulating material, and one or more layers of conductive structures may be formed on the carrier board 1 by etching or electroplating to form an integrated circuit.

In some possible implementations, the first coupling portion 331 and the second coupling portion 332 are disposed in the same conductive layer of the carrier board 1, and the signal pads 2 are disposed in another conductive layer, such as an outermost conductive layer. By disposing the mutual-capacitance structure 3 and the signal pads 2 in different conductive layers, a chip space can be effectively utilized, thereby avoiding an increase in chip size.

In some possible implementations, each of the first coupling portion and the second coupling portion may be a one-piece structure formed by etching.

In other words, the first coupling portion and the second coupling portion of the same mutual-capacitance coupling portion are disposed in the same conductive layer, and the first coupling portion and the second coupling portion may be formed by one-time etching, thereby obtaining the mutual-capacitance coupling portion having a one-piece structure. In this way, the solution of the present disclosure merely needs to modify an etching path of the conventional carrier board 1 to form the mutual-capacitance structure 3 without introducing additional process or increasing the overall size of the circuit structure 100, so that the cost can be better controlled. In other embodiments, the mutual-capacitance structure 3 may be formed on the carrier board 1 by electroplating, and the processing method of the mutual-capacitance structure 3 is selected according to size and precision requirements of the mutual-capacitance structure 3.

Since the mutual-capacitance structure 3 and the signal pads 2 are in different layers, the design of the mutual capacitance structure 3 is less constrained by size limitation, allowing greater design freedom for the mutual-capacitance structure 3, and situations of poor crosstalk cancellation effect caused by the size limitation can be reduced.

In an embodiment of the present disclosure, the connection posts 34 may be formed by drilling holes in the carrier board 1 and filling them with a conductive material, enabling cross-layer connection between the mutual capacitance structure 3 and the signal pads 2 through the connection posts 34.

In an example of the above embodiments, the mutual-capacitance coupling portion 33 is disposed in a conductive layer close to the signal pads 2; the mutual-capacitance coupling portion 33 and the signal pads 2 are separately disposed in two adjacent conductive layers, for example, the signal pads 2 are located in a bottom conductive layer, and the mutual-capacitance coupling portion 33 is located in a penultimate conductive layer, so that lengths of the connection posts 34 can be as small as possible, and the need to connect the mutual-capacitance coupling portion 33 to the signal pads 2 across a plurality of conductive layers can be obviated, thereby reducing processing difficulty, and avoiding damage to other conductive layers by the connection posts 34 when the connection posts 34 cross the layers. In other embodiments, in a case where the thickness of the circuit structure 100 is limited, the signal pads 2 and the mutual-capacitance coupling portion 33 may be disposed in the same conductive layer of the carrier board 1 to reduce the number of conductive layers, so as to reduce the thickness of the circuit structure 100.

In an embodiment of the present disclosure, the length of the first comb tooth 331a is the same as that of the second comb tooth 332a, that is, the specifications of the first coupling portion 331 and the second coupling portion 332 tend to be the same, and the first coupling portion 331 and the second coupling portion 332 merely differ in the number of the comb teeth. This facilitates the etching process, ensures proper alignment of the first and second comb teeth 331a, 332a, thereby obtains better mutual capacitance performance. It should be understood that the lengths of the first and second comb teeth 331a, 332a may differ, and those of ordinary skill in the art may set the lengths of the first and second comb teeth according to actual situations, which is not limited in the present disclosure.

In some possible implementations, the carrier board may be any one of: a package substrate, a circuit motherboard, or an interposer board. In chip products, a chip is connected to a circuit motherboard (e.g., a PCB) via a package substrate or an interposer board. In a case where the carrier board is a package substrate or an interposer board, the circuit structure of the present disclosure is disposed in the package substrate or the interposer board, and the mutual inductive coupling between any two signal pads of the package substrate or of the interposer board is cancelled out by the mutual-capacitance structure; and in a case where the carrier board is a circuit motherboard, the circuit structure of the present disclosure is disposed in the circuit motherboard, and the mutual inductive coupling between any two signal pads of the circuit motherboard is cancelled out by the mutual-capacitance structure.

It should be understood that the carrier board may be any type of board product provided with a plurality of signal pads, and the specific type of the carrier board is not limited in the present disclosure.

In an embodiment of the present disclosure, referring to FIG. 6, in a case where the carrier board is a package substrate of a chip device, the "circuit structure 100" may be a chip package structure 5, and the "carrier board 1" is the package substrate of the chip device 51. The chip package structure 5 includes the chip device 51, the package substrate, and the mutual-capacitance structure 3.

In an example of this embodiment, the chip device 51 is a main control chip (e.g., a CPU chip or an FPGA chip) provided with a DDR interface, the main control chip and the package substrate are packaged together, and the signal pads 2 and the mutual-capacitance structure 3 are located in the package substrate. In this example, the chip package structure 5 is connected to the circuit motherboard 6 (e.g., a PCB) through the interconnect structure 4 (e.g., a socket), and communicates with a DDR memory connected to the circuit motherboard 6. The interconnect structure 4 is connected to the plurality of signal pads 2 in the chip package structure 5, and may include a plurality of pins so as to be connected to the circuit motherboard 6 through the pins. Crosstalk between electric signals passing through the signal pads 2 can be reduced or cancelled out by the mutual-capacitance structure 3 disposed between the signal pads 2 in the package substrate of the main control chip.

In another example of this embodiment, the chip device 51 is a DIMM 52 provided with a DDR memory 53 (e.g., a DDR Synchronous Dynamic Random Access Memory (DDR SDRAM)), the "carrier board" is a package substrate of the DIMM 52, and the signal pads 2 and the mutual-capacitance structure 3 are located in the package substrate. In this example, the DIMM 52 is connected to the circuit motherboard 6 (e.g., a PCB) through the interconnect structure 4 (e.g., a connector), and communicates with a main control chip packaging structure (e.g., a CPU chip or an FPGA chip) connected to the circuit motherboard 6. The interconnect structure 4 is connected to the plurality of signal pads 2 in the package substrate of the DIMM 52. Crosstalk between electric signals passing through the signal pads 2 can be reduced or cancelled out by the mutual-capacitance structure 3 disposed between the signal pads 2 in the package substrate of the DIMM 52.

In an embodiment of the present disclosure, in a case that the carrier board is the circuit motherboard (e.g., a PCB), a plurality of electronic devices are disposed on the carrier board, the "circuit structure 100" may be the circuit motherboard, and the plurality of signal pads 2 and the mutual-capacitance structure 3 are located in the circuit motherboard. In an example of this embodiment, referring to FIG. 6, a main control chip packaging structure (e.g., a CPU chip or an FPGA chip) provided with a DDR interface is connected to the circuit motherboard 6, and communicates with other electronic devices on the circuit motherboard 6 via the plurality of signal pads 2 in the circuit motherboard 6, for example, the main control chip packaging structure communicates with a DIMM 52 which is provided with a DDR memory 53 and connected to the circuit motherboard 6. In another example of this embodiment, a DIMM 52 provided with a DDR memory 53 is connected to the circuit motherboard 6, and communicates with other electronic devices on the circuit motherboard 6 through the plurality of signal pads 2 in the circuit motherboard 6, for example, the DIMM 52 communicates with a main control chip which is provided with a DDR interface and connected to the circuit motherboard 6. Crosstalk between electric signals passing through the signal pads 2 may be reduced or cancelled out by the mutual-capacitance structure 3 disposed between the signal pads 2 in the circuit motherboard.

Referring to FIG. 8 and FIG. 9, as can be seen from a comparison between simulation results, for the application to DDR5 4.8 GT/s, at a Nyquist frequency of 2.4 GHz, FEXT introduced by an interconnect structure designed according to the related technology is -33 dB. After using the circuit structure 100 of the present disclosure, with the application of the mutual-capacitance structure 3, the best result is -57 dB (less than -60 dB), that is, a crosstalk reduction of 24 dB is achieved. The crosstalk is significantly reduced. Meanwhile, it is also ensured that characteristic impedance at the circuit structure 100 is close to a target wiring impedance. The above demonstrates that the present disclosure can effectively solve the crosstalk problem introduced by the interconnect structure package, and achieve excellent Signal Integrity (SI) performance.

The present disclosure further provides an electronic device, including the above circuit structure 100. Since the electronic device includes the circuit structure 100, the electronic device has all the beneficial effects of the circuit structure 100, which will not be repeated here.

In an example, as shown in FIG. 1, the electronic device further includes: a chip device 51 and an interconnect structure 4. The chip device 51 is electrically connected to the interconnect structure 4, the interconnect structure 4 has a plurality of pins 41, and the plurality of pins 41 are electrically connected to the plurality of signal pads 2, respectively.

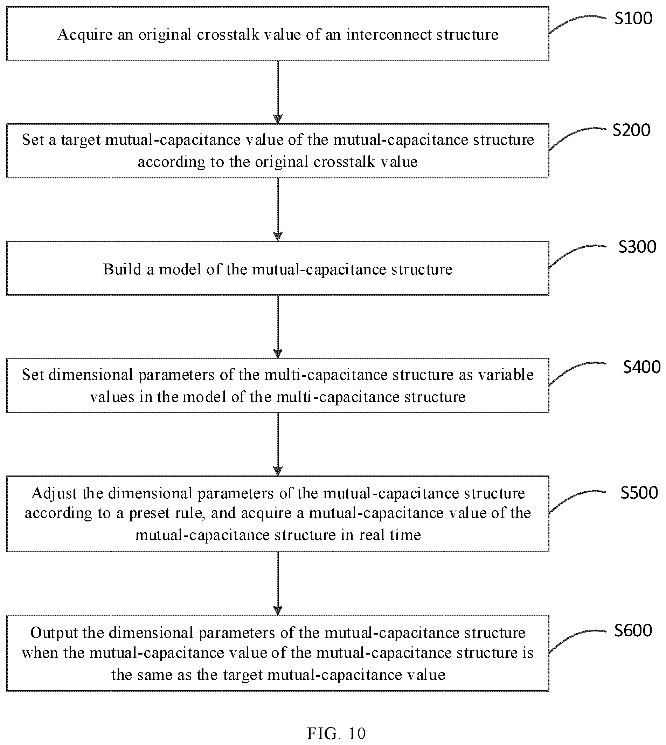

In addition, the present disclosure further provides a design method for a mutual-capacitance structure, wherein the mutual-capacitance structure is applied to the above circuit structure. As shown in FIG. 10, the design method for the mutual-capacitance structure includes the following operations S100 to S600.

At operation S100, an original crosstalk value of an interconnect structure is acquired.

The interconnect structure may refer to a circuit structure between any two signal pads where crosstalk is to be eliminated. In some possible implementations, an interconnect structure model may be built based on circuit structures corresponding to the two signal pads. In a case where the carrier board is a package substrate of a chip device, the interconnect structure model may be a Socket model; and in a case where the carrier board is a circuit motherboard, the interconnect structure model may be a PCB model of the circuit motherboard.

In some possible implementations, an S parameter of the interconnect structure model may be extracted or the S parameter and an RL parameter of the interconnect structure model may be obtained by testing, and then a calculation based on the parameters is performed to obtain the original crosstalk value of the interconnect structure. It should be understood that those of ordinary skill in the art can acquire the S parameter and the RL parameter of the interconnect structure model in various ways, and the original crosstalk value of the interconnect structure can be calculated by using conventional methods, which is not limited in the present disclosure.

At operation S200, a target mutual-capacitance value of the mutual-capacitance structure is set according to the original crosstalk value.

**In** some possible implementations, a mutual-capacitance value (referred to as the target mutual-capacitance value) required for minimizing crosstalk may be determined based on a correspondence between the crosstalk and mutual capacitance and mutual inductance (for example, an FEXT coefficient of unit length is proportional to a difference between the mutual capacitance and the mutual inductance).

**In** some possible implementations, the operation S200 of setting the target mutual-capacitance value according to the original crosstalk value may include the following operations S210 to S230.

At operation S210, calculating an ideal capacitance value of the interconnect structure based on the original crosstalk value of the interconnect structure.

At operation S220, finely adjusting the capacitance value, and acquiring the crosstalk value of the interconnect structure in real time.

At operation S230, setting the capacitance value when the crosstalk value of the interconnect structure is the minimum as the target mutual-capacitance value.

For example, a circuit schematic may be built in a circuit simulation tool according to a scenario of the interconnection structure. Since the structures of the signal pads are not regular, crosstalk between the signal pads at different positions varies. Therefore, circuit schematics need to be constructed and optimized separately for different interconnection structures.

**In** a case where the carrier board is a package substrate of a chip device, the scenario of the interconnection structure may include pins of the chip device which correspond to the two signal pads to which the chip device is connected, signal transmission circuits of the pins, circuits on the package substrate which correspond to the two signal pads, and signal transmission circuits on the package substrate which are connected to the two signal pads; and in a case where the carrier board is a circuit motherboard, the scenario of the interconnection structure may include pins of the chip device which correspond to the two signal pads to which the chip device is connected, signal transmission circuits of the pins, circuits on the package substrate which correspond to the two signal pads, and signal transmission circuits on the circuit motherboard which are connected to the two signal pads.

**In** some possible implementations, the ideal capacitance value of the interconnect structure may be calculated based on the original crosstalk value of the interconnect structure and according to the correspondence between the crosstalk and the mutual capacitance/inductance. Then, a scanning optimization may be performed using the ideal capacitance value according to the circuit schematic, that is, the capacitance value required by the interconnect structure is finely adjusted, and the crosstalk value of the interconnect structure after the capacitance value is finely adjusted is acquired in real time. By adjusting the capacitance value within a certain numerical range, a correspondence between the capacitance value and the crosstalk value of the interconnect structure is obtained and stored.

**In** some possible implementations, the capacitance value when the crosstalk value of the interconnect structure is the minimum may be set as the target mutual-capacitance value, that is, the mutual capacitance value that the mutual-capacitance structure is desired to realize for the best crosstalk suppression effect in the interconnection structure model.

**In** this way, accuracy of the set target mutual-capacitance value can be improved, thereby improving the crosstalk cancellation effect.

At operation S300, a model of the mutual-capacitance structure is built.

At operation S400, dimensional parameters of the mutual-capacitance structure are set as variable values in the model of the mutual-capacitance structure.

**In** some possible implementations, a parameterized model of the mutual-capacitance structure (e.g., a rake model or a comb model) may be manually built in the circuit simulation tool; and the dimensional parameters of the mutual-capacitance structure are set as the variable values in the model of the mutual-capacitance structure.

**In** some examples, the dimensional parameters may include a length, a width and a number of the first comb tooth and a distance between two adjacent first comb teeth, and may further include a length, a width and a number of the second comb tooth and a distance between two adjacent second comb teeth. It should be understood that the dimensional parameters of the mutual-capacitance structure may be set by those of ordinary skill in the art according to a shape and number of the mutual-capacitance coupling portion of the mutual-capacitance structure, and the dimensional parameters may further include curvature of a comb teeth. Specific types and numbers of the dimensional parameters are not limited in the present disclosure.

At operation S500, the dimensional parameters of the mutual-capacitance structure are adjusted according to a preset rule, and the mutual-capacitance value of the mutual-capacitance structure is acquired in real time.

**In** some examples, the preset rule may be an adjustment step for each dimensional parameter. **In** some examples, a variable of a single dimensional parameter such as the length of each first comb tooth may be set, and then the length of the first comb tooth is adjusted from small to large by the preset adjustment step within a preset range to obtain a comparison relationship between the single variable and the mutual-capacitance value of the mutual-capacitance structure. **In** other examples, similarly, variables of a plurality of dimensional parameters may be set, and the variable of each dimensional parameter is adjusted to obtain a comparison relationship between the variables and the mutual-capacitance value of the mutual-capacitance structure. The number of the variables may be reduced in order to simplify the calculation, for example, the parameters of the first comb tooth/teeth may be defined to be the same as those of the second comb tooth/teeth.

At operation S600, the dimensional parameters of the mutual-capacitance structure are output when the mutual-capacitance value of the mutual-capacitance structure is the same as the target mutual-capacitance value.

**In** some examples, the relevant parameters of the first comb tooth and the second comb tooth are subjected to scanning optimization to obtain the dimensional parameters of the mutual-capacitance structure matched with the interconnect structure. Finally, the dimensional parameters are finely adjusted according to process requirements to determine a final processing pattern to be applied to the whole **DDR** wiring in a package design. That is, in the present disclosure, by simulating and optimizing each mutual-capacitance structure, it is ensured that each mutual-capacitance structure has the optimal size structure in a current application scenario, thereby producing the optimal crosstalk cancellation effect.

**In** order to further improve the crosstalk cancellation effect, after the dimensional parameters of the mutual-capacitance structure are output, a mutual-capacitance structure model may be established according to the output dimensional parameters of the mutual-capacitance structure, and the mutual-capacitance structure model and the interconnect structure model are assembled to simulate the crosstalk cancellation effect in practical applications. **In** some examples, if the crosstalk between two adjacent pins of the current interconnect structure model is 0, the corresponding mutual-capacitance structure is formed on the carrier board by etching according to the output dimensional parameters of the mutual-capacitance structure; and if the crosstalk between the two adjacent pins of the current interconnect structure model is not 0, the dimensional parameters of the mutual-capacitance structure are adjusted according to the preset rule, and the crosstalk value between the two adjacent pins of the interconnect structure model is acquired in real time, and when the crosstalk value between the two adjacent pins of the interconnect structure model is the minimum, the dimensional parameters of the mutual-capacitance structure are output, and the corresponding mutual-capacitance structure is formed on the carrier board by etching according to the output dimensional parameters of the mutual-capacitance structure. The ideal capacitance value is a theoretical value, and may be further optimized by applying the simulated mutual-capacitance structure model to the interconnect structure model, so as to obtain the optimal crosstalk cancellation effect.

In this way, for different application scenarios and different positions, optimization design can be carried out for each interconnect structure, the crosstalk of which is to be cancelled out, to obtain the dimensional parameters of the mutual-capacitance structure corresponding to each interconnect structure, the corresponding mutual-capacitance structures are then etched on the carrier board respectively, and the circuit structures capable of eliminating the crosstalk are finally obtained, thereby producing an excellent crosstalk cancellation effect.

According to the circuit structure, the electronic device, and the design method for the mutual-capacitance structure provided in the embodiments of the present disclosure, the capacitive coupling effect is introduced between the adjacent signals by adding the mutual-capacitance structure of single-layer or multi-layer coplanar coupling to the package substrate or the circuit motherboard (e.g., a PCB), so that the inherent large mutual inductive coupling between the dense pins of the socket can be cancelled out, the FEXT between the adjacent signals bit can be significantly reduced (less than -60 dB) or even completely cancelled out, the parallel signal transmission problem can be solved without increasing area and cost, and the parallel signal transmission with high speed and large bandwidth can be realized.

The embodiments of the present disclosure can be applied to the scenarios of large-size chips packaged with a socket, such as a CPU chip and a Graphics Processing Unit (GPU) chip, and can realize the high-rate parallel interface transmission of DDR4, DDR5, the next-generation DDR6, and the subsequent standards.

It should be understood by those of ordinary skill in the art that the functional modules/units in all or some of the operations, the systems, and the devices disclosed above may be implemented as software, firmware, hardware, or suitable combinations thereof.

What is described above is just the preferable embodiments of the present disclosure, and is not intended to limit the scope of the present disclosure, and all equivalent structure transformations derived from the contents of the description and the drawings of the present disclosure or direct/indirect applications of the contents of the description and the drawings of the present disclosure to other related technical fields under the inventive concept of the present disclosure should be included in the scope of the present disclosure.

## Claims

1. A circuit structure, comprising a carrier board and a plurality of signal pads disposed on the carrier board, wherein the circuit structure further comprises a mutual-capacitance structure disposed on the carrier board; the mutual-capacitance structure has a first end, a second end, and a mutual-capacitance coupling portion located between the first end and the second end; and the first end and the second end of the mutual-capacitance structure are connected to two of the plurality of signal pads, respectively.

2. The circuit structure according to claim 1, wherein the mutual-capacitance coupling portion comprises a first coupling portion and a second coupling portion, one end of the first coupling portion is connected to the first end of the mutual-capacitance structure, and the other end of the first coupling portion has one or more first mutual-capacitance components; and one end of the second coupling portion is connected to the second end of the mutual-capacitance structure, and the other end of the second coupling portion has one or more second mutual-capacitance components.

3. The circuit structure according to claim 2, wherein the first coupling portion and the second coupling portion are disposed in a same conductive layer.

4. The circuit structure according to claim 2, wherein a number of the mutual-capacitance coupling portion of the mutual-capacitance structure is one or more, and wherein in a case where there are more than one mutual-capacitance coupling portions, different mutual-capacitance coupling portions are disposed in a same conductive layer or in different conductive layers.

5. The circuit structure according to claim 2, wherein the signal pads and the mutual-capacitance coupling portion are disposed in a same conductive layer or different conductive layers of the carrier board; and
wherein the carrier board further comprises a plurality of connection posts disposed between the different conductive layers, and the first coupling portion and the second coupling portion are electrically connected to the corresponding signal pads respectively through the connection posts.

6. The circuit structure according to claim 2, wherein in a case where there are a plurality of first mutual-capacitance components and a plurality of second mutual-capacitance components, the plurality of first mutual-capacitance components and the plurality of second mutual-capacitance components are staggered with each other.

7. The circuit structure according to claim 2, wherein each of the first coupling portion and the second coupling portion is a one-piece structure formed by etching.

8. The circuit structure according to any one of claims 2 to 7, wherein each first mutual-capacitance component or each second mutual-capacitance component has a shape of any one of: a shape of a straight strip, a shape of a curved strip, a shape of a plane, or a shape of a curved surface.

9. The circuit structure according to any one of claims 2 to 7, wherein the first coupling portion and the second coupling portion each have a shape of at least one of: a shape of longitudinal comb teeth, a shape of transverse comb teeth, a shape of a long strip, and a shape of a ring.

10. The circuit structure according to any one of claims 1 to 7, wherein the carrier board is any one of: a package substrate, a circuit motherboard, or an interposer board.

11. The circuit structure according to claim 10, wherein
in a case where the carrier board is a package substrate of a chip device, the circuit structure is a chip packaging structure, and the chip packaging structure comprises the chip device, the package substrate and the mutual-capacitance structure; and
in a case where the carrier board is a circuit motherboard on which a plurality of electronic devices are arranged, the electronic devices are connected to the circuit motherboard via the signal pads.

12. An electronic device, comprising the circuit structure according to any one of claims 1 to 11.

13. The electronic device according to claim 12, further comprising: a chip device and an interconnect structure, wherein the chip device is electrically connected to the interconnect structure, the interconnect structure has a plurality of pins, and the plurality of pins are electrically connected to the plurality of signal pads, respectively.

14. A design method for a mutual-capacitance structure, wherein the mutual-capacitance structure is applied to the circuit structure of any one of claims 1 to 11, and the design method comprises:
acquiring an original crosstalk value of an interconnect structure;
setting a target mutual-capacitance value of the mutual-capacitance structure according to the original crosstalk value;
building a model of the mutual-capacitance structure;
setting dimensional parameters of the mutual-capacitance structure as variable values in the model of the mutual-capacitance structure;
adjusting the dimensional parameters of the mutual-capacitance structure according to a preset rule, and acquiring a mutual-capacitance value of the mutual-capacitance structure in real time; and
outputting the dimensional parameters of the mutual-capacitance structure when the mutual-capacitance value of the mutual-capacitance structure is the same as the target mutual-capacitance value.

15. The design method according to claim 14, wherein the dimensional parameters comprise a length, a width and a number of a first mutual-capacitance component and a distance between two adjacent first mutual-capacitance components; and further comprise a length, width and number of a second mutual-capacitance component and a distance between two adjacent second mutual-capacitance components.

16. The design method according to claim 14 or 15, wherein setting the target mutual-capacitance value of the mutual-capacitance structure according to the original crosstalk value comprises:
calculating an ideal capacitance value based on the original crosstalk value;
finely adjusting a capacitance value, and acquiring a crosstalk value of the interconnect structure in real time; and
setting the capacitance value when the crosstalk value of the interconnect structure is the minimum as the target mutual-capacitance value.
